# EUROPEAN PATENT APPLICATION

(11) **EP 1 786 249 A1**
(43) Date of publication of application: **16.05.2007**
(21) Application number: 05743915.0
(22) Date of filing: 25.05.2005
(51) Int. Cl.: H05K 3/46, H05K 1/18, H05K 3/32

(54) **CERAMIC SUBSTRATE WITH CHIP TYPE ELECTRONIC COMPONENT MOUNTED THEREON AND PROCESS FOR MANUFACTURING THE SAME**

(30) Priority: 03.09.2004 JP 2004257788; 25.11.2004 JP 2004341231
(71) Applicant: MURATA MANUFACTURING CO., LTD., Nagaokakyo-shi, Kyoto 617-8555 (JP)
(72) Inventor: TSUKIZAWA, Takayuki c/o Murata Manufact. Co. Ltd., Nagaokakyo-shi, Kyoto 6178555 (JP); IKEDA, Tetsuya c/o Murata Manufact. Co., Ltd., Nagaokakyo-shi, Kyoto 6178555 (JP); CHIKAGAWA, Osamu2c/o Murata Manufact. Co., Ltd., Nagaokakyo-shi, Kyoto 6178555 (JP)
(74) Representative: Schoppe, Fritz
(86) International application number: PCT/JP2005/009576
(87) International publication number: WO 2006/027876

(57) **Abstract**

The known method for manufacturing electronic components uses solder for mounting an electronic component on a ceramic substrate. Consequently, the height of the ceramic substrate including the electronic component is increased by the amount of the solder applied. This is disadvantageous in achieving a more low-profile electronic component. Another approach may be proposed in which the electronic component is embedded in the ceramic substrate to reduce the profile. This approach however requires that a cavity be formed in the ceramic substrate.

A chip-mounted substrate 10 of the present invention includes a chip electronic component 12 on a ceramic substrate 11 having surface electrodes 11C. The chip electronic component 12 includes a ceramic sintered compact as an element assembly and terminal electrodes 12D and 12E. The surface electrodes 11C of the ceramic substrate 11 are integrated with the corresponding external terminal electrodes 12D and 12E by sintering.

## Description

### Technical Field

The present invention relates to a chip electronic component-mounted ceramic substrate and a method for manufacturing the same, and specifically to a chip electronic component-mounted ceramic substrate whose chip electronic component is mounted without using any bonding material, such as solder or electroconductive adhesive, and to a method for manufacturing the same.

### Background Art

In order to mount an electronic component on a ceramic substrate, in general, solder paste is applied to surface electrodes of a fired ceramic substrate, and the electronic component is placed on the surface electrodes with a mounter, as disclosed in, for example, Patent Document 1. The ceramic substrate having the electronic component is subjected to reflowing so that the electronic component is bonded and fixed to the ceramic substrate with the solder.

Patent Document 1: Japanese Unexamined Patent Application Publication No. 61-263297

### Disclosure of Invention

### Problems to be Solved by the Invention

Unfortunately, the known process for manufacturing ceramic substrates uses solder for mounting an electronic component on a ceramic substrate, and the height of the ceramic substrate including the electronic component is increased by the amount of the solder applied. This is disadvantageous in achieving more low-profile electronic components. Another approach may be proposed in which the electronic component is embedded in the ceramic substrate to reduce the profile. This approach however requires that a cavity be formed in the ceramic substrate.

For solder mounting, the ceramic substrate must be plated in advance. However, plating increases cost, and some of the constituents of the electrode or the ceramic may be leached into a plating bath, and consequently degrade the strength of the electrode or the substrate.

In addition, the ceramic substrate is shrunk by firing. Accordingly, a plurality of masks according to the variations in shrinkage must be prepared for applying solder paste. Also, misalignment between the mask and the ceramic substrate or variations in the amount of the paste applied limit the intervals between components, consequently limiting the deign rules for the substrate. This is one of the impediments to downsizing of the substrate. Further, the solder may be torn to short-circuit a narrow-pitch portion by reflowing for mounting electronic components. This is probably because the external terminal electrodes of the electronic component and the surface electrodes of the substrate are formed by sintering and, consequently, minute voids are produced inside the electrodes. The voids trap water during, for example, wet-plating of the electrodes. The water is vaporized and expanded by heat for reflowing. Solder mounting has other disadvantages including solder flush.

Furthermore, the substrate is required to be even for mounting the electronic component. It has been increasingly desired that the thickness of the substrate be reduced as the profile of the electronic component is reduced. In general, as the thickness of the substrate is reduced, the substrate tends to be more warped or waved by firing. A large warp or wave may cause the substrate to break when the electronic component is mounted, and this is more likely to occur as the thickness of the substrate is reduced.

In order to overcome the above-described disadvantages, the present invention provides a chip electronic component-mounted ceramic substrate and a method for manufacturing the same through which the chip electronic component can be firmly mounted on the ceramic substrate without using any bonding material, such as solder or electroconductive adhesive, and which thus can achieve high-density packaging.

### Means for Solving the Problems

The method for manufacturing a chip electronic component-mounted ceramic substrate disclosed in Claim 1 of the present invention includes the step of mounting a chip electronic component that includes a ceramic sintered compact being an element assembly and terminal electrodes, on a ceramic green body having conductors thereon such that the terminal electrodes are brought into contact with the corresponding conductors, and the step of firing the ceramic green body having the chip electronic component to integrate the conductors on the ceramic green body with the corresponding terminal electrodes of the chip electronic component by sintering.

In the method for manufacturing a chip electronic component-mounted ceramic substrate disclosed in Claim 2, the ceramic green body in Claim 1 is defined by a ceramic green sheet, and a green ceramic stack formed by stacking the ceramic green sheet having the chip electronic component and other ceramic green sheets is fired.

In the method for manufacturing a chip electronic component-mounted ceramic substrate disclosed in Claim 3, the method of Claim 2 further includes the step of forming a constraining layer on the uppermost layer or an internal layer of the green ceramic stack. The constraining layer mainly contains a sintering-resistant powder that is not substantially sintered at the sintering temperature of the ceramic green sheets.

In the method for manufacturing a chip electronic component-mounted ceramic substrate disclosed in Claim 4, the constraining layer in Claim 3 is a sheet containing the sintering-resistant powder and an organic binder.

In the method for manufacturing a chip electronic component-mounted ceramic substrate disclosed in Claim 5, the sheet of the constraining layer in Claim 4 is formed on the uppermost surface of the green ceramic stack, and the method further includes the step of pressure-bonding the constraining layer to press the chip electronic component into the ceramic green sheet.

In the method for manufacturing a chip electronic component-mounted ceramic substrate disclosed in Claim 6, the green ceramic stack having the constraining layer in Claim 5 is fired with a pressure of 0.1 to 10 MPa applied.

In the method for manufacturing a chip electronic component-mounted ceramic substrate disclosed in Claim 7, the constraining layer in Claim 3 is formed of a green compact of the sintering-resistant powder on the uppermost surface of the green ceramic stack.

In the method for manufacturing a chip electronic component-mounted ceramic substrate disclosed in Claim 8, the method of Claim 1 further includes the step of forming a constraining layer in a sheet form having via conductors arranged corresponding to the terminal electrodes of the chip electronic component, on the ceramic green body to form the conductors. The constraining layer contains a sintering-resistant powder that is not substantially sintered at the sintering temperature of the ceramic green body and an organic binder.

In the method for manufacturing a chip electronic component-mounted ceramic substrate disclosed in Claim 9, the chip electronic component of any one of Claims 1 to 8 is mounted on the conductors on the ceramic green body with an organic adhesive therebetween.

In the method for manufacturing a chip electronic component-mounted ceramic substrate disclosed in Claim 10, the ceramic green body of any one of Claims 1 to 9 is defined by a ceramic green sheet mainly containing a low-temperature co-fired ceramic powder, and the terminal electrodes of the chip electronic component and the conductors on the ceramic green sheet are formed of an electrode material mainly containing silver, copper, or gold.

The chip electronic component-mounted ceramic substrate disclosed in Claim 11 of the present invention includes a chip electronic component mounted on a ceramic substrate having surface electrodes. The chip electronic component includes a ceramic sintered compact as an element assembly and terminal electrodes. The surface electrodes of the ceramic substrate are integrated with the corresponding terminal electrodes of the chip electronic component by sintering.

The chip electronic component-mounted ceramic substrate disclosed in Claim 12 of the present invention includes a chip electronic component mounted on a ceramic substrate having surface electrodes. The chip electronic component includes a ceramic sintered compact as an element assembly and terminal electrodes. The surface electrodes of the ceramic substrate are connected to the corresponding terminal electrodes of the chip electronic component in a filletless manner without using solder or electroconductive adhesive.

In the chip electronic component-mounted ceramic substrate disclosed in Claim 13, the surface electrodes in Claim 11 or 12 is bump electrodes.

In the chip electronic component-mounted ceramic substrate disclosed in Claim 14, at least part of the chip electronic component in Claim 11 or 12 is embedded in the surface of the ceramic substrate.

In the chip electronic component-mounted ceramic substrate disclosed in Claim 15, the ceramic substrate in any one of Claims 11 to 14 is a multilayer ceramic substrate formed by stacking a plurality of low-temperature co-fired ceramic layers, and the terminal electrodes of the chip electronic component and the surface electrodes of the multilayer ceramic substrate mainly contain silver, copper, or gold.

### Advantages

The present invention can provide a chip electronic component-mounted ceramic substrate and a method for manufacturing the same through which a chip electronic component is firmly mounted on the ceramic substrate without using any bonding material, such as solder or electroconductive adhesive, and which thus can achieve high-density packaging.

### Brief Description of the Drawings

Figs. 1(a) and 1(b) are fragmentary enlarged sectional view of a chip electronic component-mounted ceramic substrate according to an embodiment of the present invention: (a) is a sectional view of an essential part of the chip electronic component-mounted ceramic substrate; (b) is a sectional view of the same part before firing.
Figs. 2(a) to 2(e) are representations of process steps in the order of procedure of a method for manufacturing the chip electronic component-mounted ceramic substrate shown in Fig. 1.
Figs. 3(a) to 3(c) are representations of process steps following the steps shown in Fig. 2.
Fig. 4 is a sectional view of a chip electronic component-mounted ceramic substrate according to another embodiment of the present invention.
Fig. 5 is a representation of a method for manufacturing a chip electronic component-mounted ceramic substrate according to another embodiment of the present invention, corresponding to Fig. 3(a).
Figs. 6(a) to 6(c) are representations of process steps in the order of procedure of a method for manufacturing a chip electronic component-mounted ceramic substrate according to another embodiment of the present invention.
Figs. 7(a) and 7(b) are representations of process steps in the order of procedure of a method for manufacturing a chip electronic component-mounted ceramic substrate according to another embodiment of the present invention.
Fig. 8 is a representation of an essential part in a method for manufacturing a chip electronic component-mounted ceramic substrate according to still another embodiment of the present invention.
Figs. 9(a) and 9(b) are representations of essential parts in a method for manufacturing a chip electronic component-mounted ceramic substrate according to still another embodiment of the present invention.
Figs. 10(a) and 10(b) are representations of essential parts in a method for manufacturing a chip electronic component-mounted ceramic substrate according to still another embodiment of the present invention.
Figs. 11(a) and 11(b) are representations of essential parts in a method for manufacturing a chip electronic component-mounted ceramic substrate according to still another embodiment of the present invention.
Fig. 12 is a fragmentary sectional view of a chip electronic component-mounted ceramic substrate according to still another embodiment.

### Reference Numerals

10, 10A, 10C, 10D, 10F, 10G, 10H, 10I: chip-mounted substrate (chip electronic component-mounted ceramic substrate)
11: multilayer ceramic substrate
11B: wiring pattern
11C: in-plane conductor, surface electrode
11D: bump electrode
11E: constraining layer
12: chip electronic component
12D, 12E: external terminal electrode (terminal electrode)
111: green ceramic stack
111A: ceramic green sheet (ceramic green body)
111C: surface electrode (conductor)
111D: via conductor (conductor)
112: ceramic sintered compact
112D, 112E: external terminal electrode
114, 114B, 114C: constraining layer
114A: green compact (constraining layer)

### Best Mode for Carrying Out the Invention

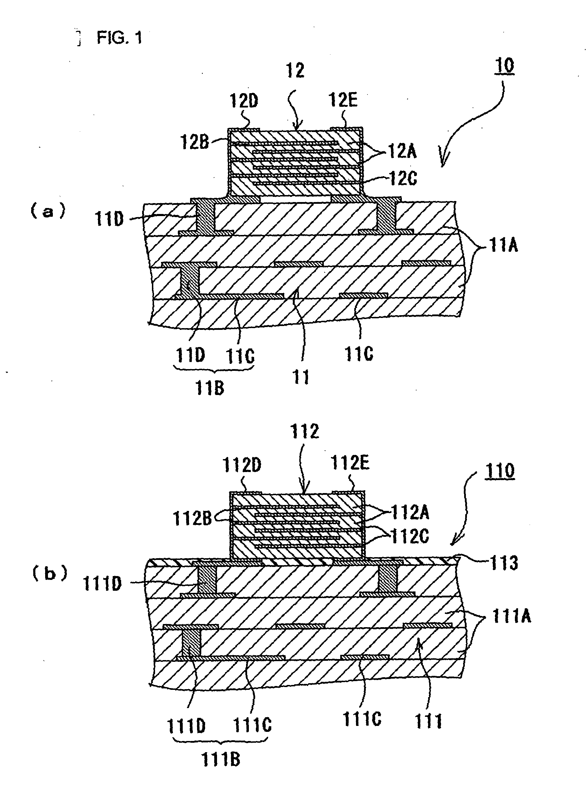

The present invention will now be described with reference to embodiments shown in Figs. 1 to 12.

A chip electronic component-mounted ceramic substrate (hereinafter simply referred to as "chip-mounted substrate") 10 according to the present embodiment includes a ceramic substrate 11 and a chip electronic component 12 mounted on the ceramic substrate 11, as shown in, for example, Fig. 1(a). The surface electrodes of the ceramic substrate 11 are connected to the corresponding external terminal electrodes of the chip electronic component 12 in a substantially filletless manner without using solder or electroconductive adhesive, as described later.

The ceramic substrate 11 has a multilayer structure including a stack of a plurality of ceramic layers 11A and wiring patterns 11B formed in predetermined patterns in the stack, as shown in Fig. 1(a). The ceramic substrate 11 may be such a multilayer ceramic substrate, or a single-layer ceramic substrate. In the following description, the ceramic substrate 11 refers to the multilayer ceramic substrate 11. The wiring patterns 11B of the multilayer ceramic substrate 11 each include in-plane conductors 11C formed in a predetermined pattern on a predetermined ceramic layer 11A and via conductors 11D electrically connecting the overlying and underlying in-plane conductors 11C. The in-plane conductors 11C disposed on both principal surfaces (upper and lower surfaces) of the multilayer ceramic substrate 11 are used as the surface electrodes of the ceramic substrate 11. In the following description, the in-plane conductors 11C on the upper and lower surfaces of the multilayer ceramic substrate 11 are referred to as surface electrodes 11C.

The ceramic layer 11A is preferably formed of a low-temperature co-fired ceramic (LTCC) material. The low-temperature co-fired ceramic material refers to a ceramic material capable of being fired at a temperature of 1050°C or less. Examples of the low-temperature co-fired ceramic material include: glass composite materials containing ceramic powder, such as alumina, forsterite, or cordierite, and borosilicate glass; crystallized glass materials containing ZnO-MgO-Al₂O₃-SiO₂ crystallized glass; and non-glass materials containing BaO-Al₂O₃-SiO₂ ceramic powder or Al₂O₃-CaO-SiO₂-MgO-B₂O₃ ceramic powder. By using the low-temperature co-fired ceramic material in the multilayer ceramic substrate 11, the in-plane conductors 11C and via conductors 11D can be formed of a low-resistance, low-melting-point metal, such as silver (Ag), copper (Cu), or gold (Au), and thus can be simultaneously sintered and integrated with the ceramic layer at a low temperature.

Examples of the chip electronic component 12 include monolithic ceramic capacitors, inductors, filters, baluns, and couplers, and the characteristics of these chip electronic components are not degraded at the firing temperature of the multilayer ceramic substrate 11. These chip electronic components may be used singly or in combination.

The chip electronic component 12 shown in Fig. 1(a) is a monolithic ceramic capacitor. This chip electronic component 12 includes a stack of a plurality of dielectric ceramic layers 12A, a plurality of internal electrode layers 12B and 12C alternately extending in the transverse direction from either side of the stack toward the other side, each lying between the underlying and overlying dielectric ceramic layers 12A, and a pair of external terminal electrodes 12D and 12E respectively connected to one ends of the internal electrode layers 12B and 12C and covering both sides of the stack, as shown in Fig. 1(a). A known dielectric ceramic material, such as barium titanate-based material, can be used for the dielectric ceramic layers. Hence, the element assembly of the chip electronic component 12 is formed of a ceramic sintered compact whose characteristics are not substantially varied at the firing temperature of the multilayer ceramic substrate 11. The internal electrodes 12B and 12C and the external terminal electrodes 12D and 12E may be formed of, for example, an electroconductive metal that is the same as or different from that of the wiring patterns 11B of the multilayer ceramic substrate 11.

In this structure, the surface electrodes 11C of the multilayer ceramic substrate 11 are tightly connected to the corresponding external terminal electrodes 12D and 12E of the chip electronic component 12 with no interfaces between the surface electrodes 11C and the external terminal electrodes 12D and 12E, as shown in Fig. 1(a), by sintering through which the metal grains, such as Ag, Cu, or Au, in these electrodes are grown and integrated by firing. In other wards, the surface electrodes 11C of the multilayer ceramic substrate 11 are connected to the corresponding external terminal electrodes 12D and 12E of the chip electronic component 12 in a filletless manner without using solder or electroconductive adhesive.

While the details of the method for manufacturing the chip-mounted substrate 10 shown in Fig. 1(a) will be described later, the outline of the method is as below. As shown in Fig. 1(b), a ceramic sintered compact 112 having a pair of external terminal electrodes 112D and 112E at the right and left sides are bonded and fixed to a ceramic green body 111 having in-plane conductors 111C acting as the surface electrodes with an organic adhesive layer 113 therebetween, with the in-plane conductors 111C aligned with the corresponding external terminal electrodes 112D and 112E. The resulting structure is fired at a predetermined temperate to complete the chip-mounted substrate 10. By this firing, the surface electrodes 11C of the multilayer ceramic substrate 11 and the external terminal electrodes 12D and 12E of the chip electronic component 12 are sintered to be integrated, and thus firmly connected to each other. In this instance, the external terminal electrodes 112D and 112E of the ceramic sintered compact 112 may or may not have already been sintered, and are not necessarily coated with a plating film. The ceramic green body may be a single layer of a ceramic green sheet 111A, or a stack of a plurality of ceramic green sheets 111A as shown in Fig. 1(b). Also, the ceramic green body may or may not have the wiring pattern including the in-plane conductors and via conductors.

In the present embodiment, the chip-mounted substrate is produced by a constrained sintering process. In the constrained sintering process, the horizontal dimensions of the ceramic substrate are not changed by firing. In order to realize the constrained sintering process, the present embodiment uses a constraining layer for preventing the ceramic green sheets from shrinking in the surface direction, but mainly helping the ceramic green sheets shrink in the stacking direction (vertical direction). The constraining layer is disposed on at least either principal surface (upper surface and/or lower surface) of the stack of the ceramic green sheets or inside the stack. The chip-mounted substrate is thus produced in the presence of the constraining layer.

### Examples

The method for manufacturing the chip-mounted substrate using the constrained sintering process will now be described with reference to the following specific examples.

### EXAMPLE 1

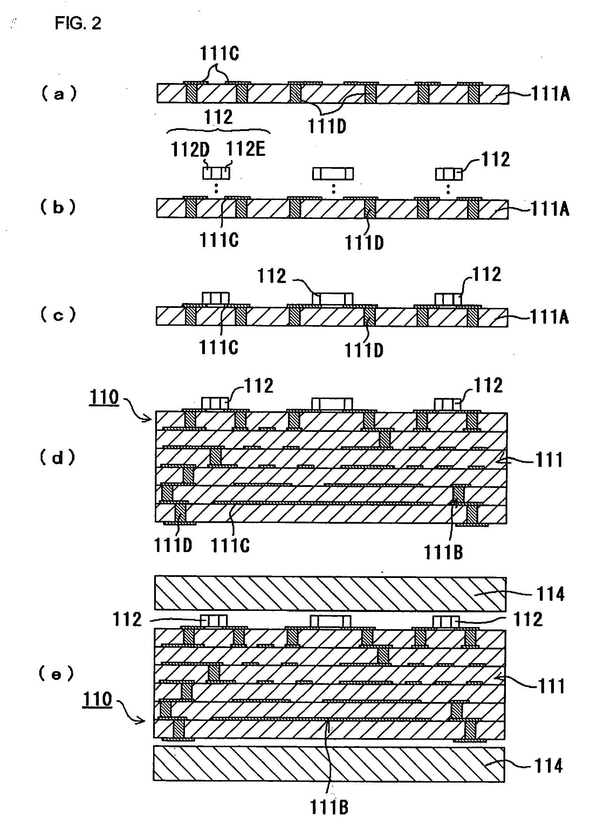

In the present example, first, a predetermined number of ceramic green sheets 111A were formed of, for example, a slurry containing a low-temperature co-fired ceramic material, as shown in Fig. 2(a). Then, one of the ceramic green sheets 111A was provided with via holes in a predetermined pattern. The via holes were filled with a conductive paste mainly containing, for example, Ag, Cu, or Au to form via conductors 111D. The same conductive paste was further applied in a predetermined pattern onto the ceramic green sheet 111A by screen printing to form in-plane conductors 111C intended as the surface electrodes. The in-plane conductors 111C were thus connected to the via conductors 111D as appropriate. The other ceramic green sheets 111A were also provided with in-plane conductors 111C and via conductors 111D in respective patterns in the same manner. In the following description, the in-plane conductors 111C on the upper surface of the uppermost ceramic green sheet 111A are referred to as the surface electrodes 111C.

Then, an organic adhesive was applied onto the surface (upper surface) having the surface electrodes 111C of the ceramic green sheet 111A shown in Fig. 2(a) by spraying or the like to form an organic adhesive layer 113 (see Fig. 1(b)). Subsequently, previously prepared ceramic sintered compacts 112 were disposed as element assemblies on the ceramic green sheet 111A, as shown in Fig. 2(b), with the surface electrodes 111C of the ceramic green sheet 111 aligned with the corresponding external terminal electrodes 112D and 112E of the ceramic sintered compacts 112. The ceramic sintered compacts 112 and the ceramic green sheet 111A were bonded and fixed to each other with the organic adhesive layer therebetween, as shown in Fig. 2(c). Thus, the ceramic green sheet 111A having the ceramic sintered compacts 112 was prepared. The ceramic sintered compacts 112A were, for example, barium titanate-based monolithic ceramic capacitors. The ceramic sintered compact 112 measured, for example, 1 mm by 0.5 mm by 0.2 mm and had a capacitance specification of 80 pF. The same monolithic ceramic capacitors were used as the ceramic sintered compacts 112 of the chip electronic components in the following examples as well.

Then, the other ceramic green sheets 111A having the in-plane conductors 111C and the via conductors 111D were stacked in a predetermined order, and the ceramic green sheet 111A having the ceramic sintered compacts 112 was disposed on the uppermost ceramic green sheet to prepare a green ceramic stack 111 shown in Fig. 2(d). Turning to Fig. 2(e), constraining layers 114 were opposed to the principal surfaces (upper and lower surfaces) of the ceramic stack 111. The constraining layers 114 were formed of a sintering-resistant powder (for example, high-sintering-temperature ceramic powder, such as Al₂O₃) that is not sintered at the sintering temperature of the ceramic stack 111. Specifically, a slurry containing Al₂O₃ as a main constituent and an organic binder as an accessory constituent was formed into sheets, as shown in Fig. 2(e).

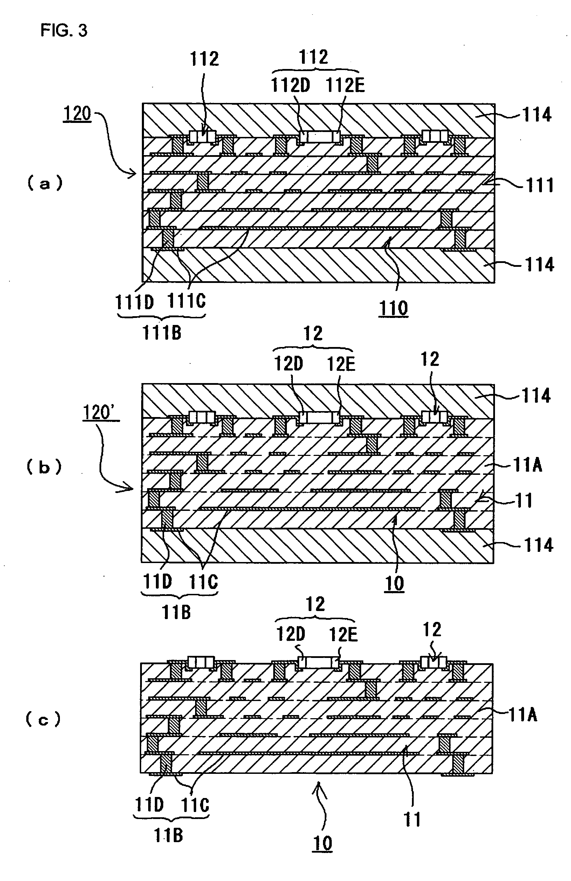

Then, the green ceramic stack 111 was pressure-bonded at a predetermined pressure from the upper and lower constraining layers 114 at a predetermined temperature to prepare a green multilayer composite 120 as shown in Fig. 3(a). Thus, the unfired chip-mounted substrate 110 was formed between the upper and lower constraining layers 114. By this pressure bonding, at least part of the ceramic sintered compacts 112 were pressed into the uppermost ceramic green sheet 111A to reduce the profile of the green multilayer composite 120. The pressure bonding is preferably performed at a pressure in the range of, for example, 1 to 250 MPa. A pressure of less than 1 MPa cannot sufficiently pressure-bond the surface electrodes 111C of the ceramic green sheet 111A to the external terminal electrodes 112D and 112E of the ceramic sintered compact 112, and may result in connection failure. A pressure of more than 250 MPa may break the in-plane conductors 111C and the via conductors 111D. Preferably, the uppermost ceramic green sheet 111A has a larger thickness than the other ceramic green sheets. This is because the deformation of the wiring patterns in the other ceramic green sheets is prevented by volume exclusion effect. Alternately, a buffer ceramic green sheet that has no wiring pattern for forming capacitors, inductors, or other functional elements may be disposed between the uppermost ceramic green sheet 111A and the other ceramic green sheets.

Then, the green multilayer composite 120 was fired at 870°C to prepare a sintered compact 120' shown in Fig. 3(b). By this firing, the unfired chip-mounted substrate 110 was sintered to turn into the chip-mounted substrate 10 including the multilayer ceramic substrate 11 and the chip electronic components 12 between the upper and lower constraining layers 114. At this time, the metal grains in each electrode are grown to integrate, so that the surface electrodes 111C of the green ceramic stack 111 are firmly connected to the corresponding external terminal electrodes 112D and 112E of the ceramic sintered compact 112. The firing is preferably performed at a temperature at which the low-temperature co-fired ceramic material sinters, for example, in the range of 800 to 1050°C. A firing temperature of less than 800°C may not sufficiently sinter the ceramic stack 110, and a firing temperature of more than 1050°C may melt the metal grains in the electrodes 111C, 112D, and 112E to diffuse into the ceramic layers.

After the firing, the constraining layers 114 were removed by blasting or ultrasonic cleaning to complete the chip-mounted substrate 10 shown in Fig. 3(c). Then, the adhesion of the chip electronic component 12 to the multilayer ceramic substrate 11 was measured by horizontal push test, and an adhesion of 3 N or more resulted. Also, the capacitance of the chip electronic component (monolithic ceramic capacitor) 12 was measured, and the same result as before firing, within the specifications, was obtained.

As described above, the present example can provide a chip-mounted substrate 10 in which the surface electrodes 11C of the multilayer ceramic substrate 11 are integrally connected to the external terminal electrodes 12D and 12E of the chip electronic components 12 by sintering in a filletless manner without using solder or electroconductive adhesive. In addition, the example can provide a chip-mounted substrate 10 whose chip electronic components 12 are partially embedded in the multilayer ceramic substrate 11 to reduce the profile. Furthermore, since the chip-mounted substrate 10 does not use solder, the surface electrodes 11C of the multilayer ceramic substrate 11 and the external terminal electrodes 12D and 12E of the chip electronic components 12 do not need to be plated and, consequently, the manufacturing cost can be reduced. In the present example, the green ceramic stack 110 is fired while being constrained by the constraining layers 114, so that the green ceramic stack 110 is greatly prevented from shrinking in the transverse direction, but shrinks mainly in the stacking direction (vertical direction). Thus, the chip electronic components, whose dimensions are not change by firing, are prevented from cracking or breaking even though the chip electronic components are fired with the stack. Consequently, the example can provide a dimensionally precise chip-mounted substrate 10 in which variations in dimensions before and after firing are greatly reduced.

### EXAMPLE 2

The present example produced chip-mounted substrates 10 in the same manner as in Example 1, except that the green multilayer composites 120 shown in Fig. 3(a) were fired while being pressed at different pressures in the range shown in Table 1.

Specifically, in the present example, the green multilayer composites 120 were fired while being pressed at different pressures in the range of 0 to 15 MPa, as shown in Table 1, and the resulting chip-mounted substrates were each measured for the adhesion strength of the chip electronic components 12 to the multilayer ceramic substrate 11 and the degree of embedment in the multilayer ceramic substrate 11 for the pressured applied. The measurements of the degree of embedment and adhesion strength were performed by horizontal push test. In the horizontal push test, a load jig (end diameter: 0.3 mm; material: hardened steel (hardness: HB183)) was brought into contact with a side surface of the chip electronic component 12, perpendicular to the line connecting both external terminal electrodes 12D and 12E of the chip electronic component 12, and a load was applied at a loading speed of 0.5±0.1 mm/s. The load when the component came off was measured. For measuring the degree of embedment, the chip-mounted substrate 10 was cut and polished, and the degree of embedment was obtained by subtracting the height of the multilayer ceramic substrate 11 up to the top surface from the height of the bottom of the chip electronic component 12. A solder-mounted sample was also subjected to the same tests for reference purpose. The results are shown in Table 1. "Measurement impossible" in the horizontal push test shown in Table 1 means that the chip electronic component 12 did not come off from the multilayer ceramic substrate 11 by loads of the horizontal push test, but was tightly bonded to the substrate.

**[Table 1]**

| Applied pressure during firing (MPa) | Degree of embedment (µm) | Horizontal push test (N) |
|---|---|---|
| 0 | 0 | 3 |
| 0.05 | -10 | 3 |
| 0.1 | -30 | 10 |
| 0.5 | -150 | 43 |
| 1 | -200 | Measurement impossible |
| 2 | -200 | Measurement impossible |
| 5 | -200 | Measurement impossible |
| 15 | Substrate cracked | - |
| Solder mounting | 100 | 3 |

Table 1 shows that an applied pressure of less than 0.1 MPa produces the same results as for the solder mounted sample in the horizontal push test, and that an applied pressure of 15 MPa, that is, more than 10 MPa, causes a crack in the multilayer ceramic substrate 11. Accordingly, it has been found that the preferred pressure is in the range of 0.1 to 10 MPa, from the viewpoint of tightly bonding the chip electronic components 12 to the multilayer ceramic substrate 11 and reducing the profile of the chip-mounted substrate 10. In particular, by applying a pressure of 1 MPa or more, the chip electronic component 12 can be fully embedded in the multilayer ceramic substrate 11, so that the upper surface of the chip electronic component 12 becomes flush with the upper surface of the multilayer ceramic substrate 11 to form a plat surface, thus achieving a low-profile chip-mounted substrate with no protrusions. In addition, the same effects as in Example 1 can be expected.

### EXAMPLE 3

The present example produced a chip-mounted substrate in the same manner as in Example 1, except that the constraining layers were provided inside the green ceramic stack and left in the multilayer ceramic substrate, instead of being provided on the upper and lower surfaces of the green ceramic stack. In the present example, parts that are the same as or correspond to those in Example 1 are designated by the same numerals.

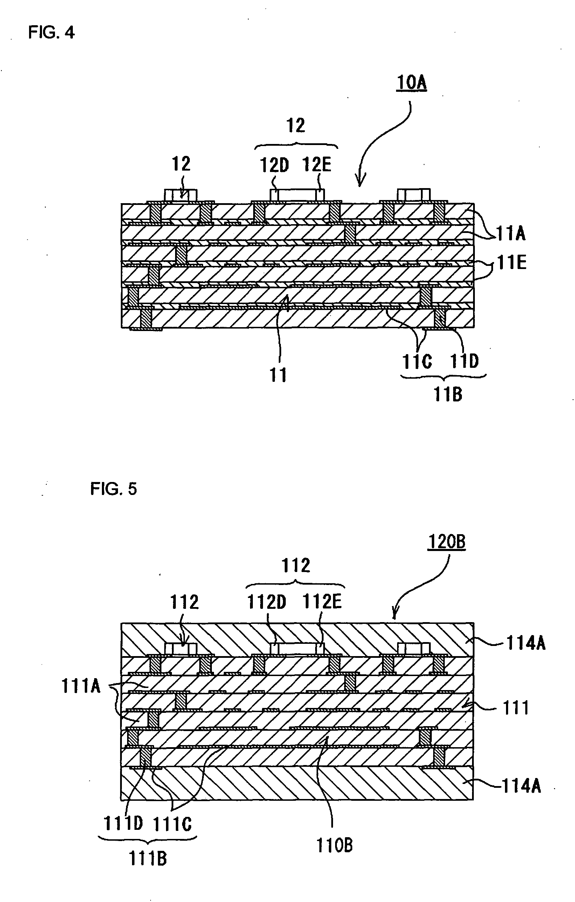

The chip-mounted substrate 10A of the present example has the same structure as in Example 1, as shown in, for example, Fig. 4, except for the multilayer ceramic substrate 11. The multilayer ceramic substrate 11 in the present example is formed by alternately stacking a plurality of ceramic layers 11A and a plurality of constraining layers 11E, as shown in Fig. 4. Each constraining layer 11E is a sheet formed of the same material as the constraining layer 114 used in Example 1, and lies between its underlying and overlying ceramic layers 11A.

The feature of the method for manufacturing the chip-mounted substrate 10A of the present example will now be described. In the present example, the ceramic green sheets were formed in the same manner as in Example 1, and then the same slurry as in Example 1, containing Al₂O₃ as a main constituent and an organic binder as an accessory constituent was applied to the surfaces of the ceramic green sheets. Thus, a predetermined number of composite sheets, each including the ceramic green sheet and the constraining layer were formed. Preferably, the ceramic green sheet of the composite sheet has a larger thickness than the constraining layer. For example, the thickness of the ceramic green sheet is 5 to 20 times as large as that of the constraining layer.

Then, one of the composite sheets was provided with via holes in a predetermined pattern, and the via holes were filled with a conductive paste mainly containing, for example, Ag, Cu, or Au to form via conductors. Further, the same conductive paste was applied in a predetermined pattern to the surface of the ceramic green sheet of the composite sheet by screen printing to form surface electrodes, and thus the surface electrodes were appropriately connected to the via conductors. The other composite sheets were provided with in-plane conductors and via conductors in their respective patterns in the same manner, if necessary. Ceramic sintered compacts were disposed as element assemblies on the composite sheet intended as the uppermost layer and fixed to the composite sheet with an organic adhesive layer therebetween, in the same manner as in Example 1.

Then, a ceramic green sheet having the in-plane conductors and the via conductors was placed as the lowermost layer, and the rest of the composite sheets were stacked in a predetermined order in such a manner that the ceramic green sheets and the constraining layers were brought into contact with each other. Subsequently the composite sheet having the ceramic sintered compacts was disposed as the uppermost layer, and thus a green ceramic stack was prepared. The green ceramic stack has the same multilayer structure as the chip-mounted substrate 10A shown in Fig. 4. The green ceramic stack was pressure-bonded and fired in the same manner as in Example 1 to complete the chip-mounted substrate 10A shown in Fig. 4.

The sintering-resistant powder (for example, Al₂O₃) in the constraining layers disposed inside the green ceramic stack is not sintered at the firing temperature of the ceramic green sheets. In the present example, however, the glass components in the ceramic green sheets melt and move to diffuse throughout the grains of the Al₂O₃ powder forming the constraining layers at the firing temperature, and the Al₂O₃ powder grains in the constraining layer 11E are bonded and integrated together with the glass components after cooling. Simultaneously, the constraining layers 11E and the ceramic layers 11A are tightly bonded and integrated into the multilayer ceramic substrate 11. Then, the constraining layers prevent the green ceramic stack from shrinking in the surface direction (transverse direction), thus achieving the multilayer ceramic substrate 11 whose dimensions are hardly changed by firing, as in Example 1. If all the ceramic green sheets have substantially the same thickness, the multilayer ceramic substrate 11 can be prevented from warping.

As described above, the present example can reduce the transverse shrinkage and dimensional variations resulting from firing, and accordingly can achieve a dimensionally precise chip-mounted substrate 10A with no warp. Hence, the manufacturing method of the present example can produce a chip-mounted substrate with a dimensional precision increased as it becomes larger, and in which the warp is greatly reduced. In the present example as well as in Example 2, the chip electronic components 12 are tightly fixed to the multilayer ceramic substrate 11 by firing with a pressure applied.

### EXAMPLE 4

The present example produced a chip-mounted substrate in the same manner as in Example 1, except that the constraining layers used in Example 1 were replaced with green compacts. The green compact used herein is formed by compacting a mixture of, for example, ceramic powder and an organic binder at a predetermined pressure. In the present example, parts that are the same as or correspond to those in Example 1 are designated by the same numerals.

In the present example, first, a green ceramic stack 111 (see Fig. 5) was prepared in the same manner as in Example 1. After the green compacts 114A were disposed on the upper and lower surfaces of the ceramic stack 111, the green ceramic stack 111 was pressure-bonded at a predetermined pressure from the upper and lower green compacts 114A at a predetermined temperature to prepare a multilayer composite 120B shown in Fig. 5. In this state, an unfired chip-mounted substrate 110B lies between the upper and lower constraining layers 114. The constraining layer used in the present example is formed of ceramic powder as it is, different from the constraining layer in a sheet form used in Example 1. When the green compact 114A presses the upper surface of the ceramic stack 11, the ceramic powder of the green compact 114A moves to flow into the steps formed by the upper surfaces of the ceramic sintered compacts 112 and the uppermost ceramic green sheet 111A and fills the steps. The ceramic powder can thus fill the spaces between the ceramicsintered compacts 112, even if the spaces are so small as, for example, a sheet cannot fill them. Thus, the green compacts 114A can cover the upper and lower surfaces of the ceramic stack 111.

After the multilayer composite 120B was fired in the same manner as in Example 1, the green compacts 114A were removed to complete a chip-mounted substrate (not shown). By this firing, the surface electrodes of the multilayer ceramic substrate were integrated with the corresponding external terminal electrodes of the chip electronic components and tightly connected to them, as in Example 1. Consequently, the same effects as in Example 1 were produced.

While, in the above-described examples, the ceramic sintered compacts are bonded to a ceramic green sheet before ceramic green sheets are stacked in a predetermined order to form a green ceramic stack, a predetermined number of ceramic green sheets may be stacked to form a green ceramic stack and then the ceramic sintered compacts are disposed as element assemblies on the ceramic stack.

### EXAMPLE 5

The present example produced a chip-mounted substrate in the same manner as in Example 1, except that bump electrodes connected to the external terminal electrodes of the chip electronic components were formed on the green ceramic stack using a constraining layer, instead of the surface electrodes 11C used in the foregoing examples. In the present example, parts that are the same as or correspond to those in Example 1 are designated by the same numerals.

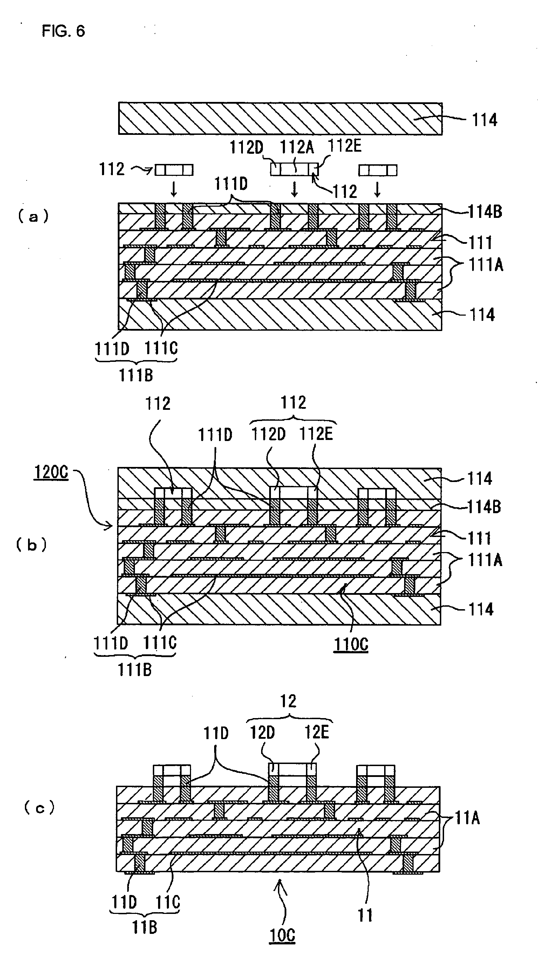

The chip-mounted substrate 10C of the present example has the same structure as in Example 1, except that the external terminal electrodes 12D and 12E of the chip electronic components 12 are connected to bump electrodes 11D protruding from the upper surface of the multilayer ceramic substrate 11, as shown in, for example, Fig. 6(c). The bump electrodes 11D are formed using a via-forming constraining layer 114B, as shown in Figs. 6(a) and 6(b).

The feature of the method for manufacturing the chip-mounted substrate 10C of the present example will now be described. In the present example, the via-forming constraining layer 114B is prepared which has via conductors 111D that is to be connected to the external terminal electrodes 112D and 112E of the ceramic sintered compacts 112, as shown in Figs. 6(a) and 6(b), in addition to forming the constraining layers 114 disposed on the upper and lower surfaces of the green ceramic stack 111, as in Example 1. For the formation of the via-forming constraining layer 114B, the same slurry as used in Example 1, containing Al₂O₃ as the main constituent and an organic binder as an accessory constituent was formed into a sheet. Then, via holes were formed in a predetermined pattern in the via-forming constraining layer 114B and were filled with a conductive paste, in the same manner as via conductors were formed in the ceramic green sheet in Example 1. Thus, via conductors 111D intended as the bump electrodes 11D as shown in Figs. 6(a) and 6(b) were formed in such a manner as to correspond to the external terminal electrodes of the ceramic sintered compacts 12, and thus the via-forming constraining layer 114B was prepared. In addition, a predetermined number of ceramic green sheets 111A having in-plane conductors 111C and via conductors 111D were formed in the same manner as in Example 1.

Then, the ceramic green sheets 111A were stacked in a predetermined order to form the green ceramic stack 111 on a constraining layer 114, as shown in Fig. 6(a), and the via-forming constraining layer 114B is disposed on the upper surface of the green ceramic stack 111 to form the via conductors 111D on the green ceramic stack 111. After an organic adhesive layer was formed on the upper surface of the via-forming constraining layer 114B in the same manner as in Example 1, the via conductors 111D in the via-forming constraining layer were aligned with the corresponding external terminal electrodes 112D and 112E of the ceramic sintered compacts 112 intended as chip electronic components, and the ceramic sintered compacts 112 were placed on the via conductors 111D in the via-forming constraining layer 114B, as designated by the arrows in Fig. 6(a). The external terminal electrodes 112D and 112E of the ceramic sintered compacts 112 were thus joined and fixed to the via conductors 111D with the organic adhesive layer therebetween. Another constraining layer 114 was disposed over the ceramic sintered compacts 112 to prepare a green multilayer composite 120C shown in Fig. 6(b). In this state, an unfired chip-mounted substrate 110C lies between the upper and lower constraining layers 114. The green multilayer composite 120C was pressure-bonded in the same manner as in Example 1 and subsequently fired to complete the chip-mounted substrate 10C shown in Fig. 6(c). Reference numeral 110C in Fig. 6(b) designates an unfired chip-mounted substrate.

The chip-mounted substrate 10C of 105 mm square and 0.5 mm thickness of the present example was measured for warp. The chip-mounted substrate 10 with the same dimensions produced in Example 1 was also measured for warp. The results are shown in Table 2.

**[Table 2]**

| | Degree of warp/mm |
|---|---|
| Example 1 | 0.121 |
| Example 5 | 0.084 |

Table 2 shows that the warp of the chip-mounted substrate 10C of the present example was much more reduced than that of the chip-mounted substrate 10 of Example 1. This means that the warp or wave of the multilayer ceramic substrate 11 can be further reduced in comparison with the case where the bump electrodes 11D are formed using the ceramic green sheet 111A. The via-forming constraining layer 114B prevents the regions immediately under the chip electronic components 12 from shrinking when the bump electrodes 11D are formed.

### EXAMPLE 6

The present example produced a chip-mounted substrate in the same manner as in Example 1, except that the chip electronic components were mounted on both the upper and the lower surface of the multilayer ceramic substrate. In the present example, parts that are the same as or correspond to those in Example 1 are designated by the same numerals.

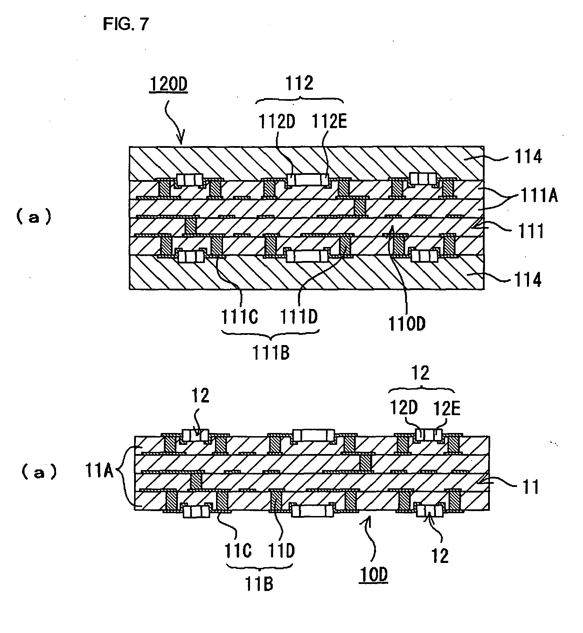

In the present example, after a predetermined number of ceramic green sheets 111A (four in Fig. 7(a)) were formed in the same manner as in Example 1, the ceramic green sheets 111A were provided with in-plane conductors 111C and via conductors 111D as required, as shown in Fig. 7(a). Constraining layers 114 were also formed in the same manner as in Example 1. Then, after an organic adhesive layer was formed on the upper surface of either constraining layer 114, a plurality of ceramic sintered compacts 112 being element assemblies of the chip electronic components 12 were disposed on predetermined regions of the upper surface of the constraining layer 114, followed by bonding and fixing.

At the same time, the four ceramic green sheets 111A were stacked in a predetermined order to form a green ceramic stack 111, and subsequently an organic adhesive layer (not shown) was formed on the upper surface of the green ceramic stack 111. Then, the in-plane conductors (surface electrode) 111C on the upper surface of the green ceramic stack 111 were each aligned with the corresponding external terminal electrodes 112D and 112E of the ceramic sintered compacts 112, and subsequently each ceramic sintered compact 112 was joined and fixed to the surface electrodes 111C on the green ceramic stack 111 with the corresponding external terminal electrode 112D or 112E therebetween. The green ceramic stack 111 has surface electrodes 111C on the lower surface, corresponding to the pattern of the external terminal electrodes 112D and 112E of the ceramic sintered compacts 112 previously provided on the constraining layer 114 (see Fig. 7(a)).

The surface electrodes 111C on the lower surface of the green ceramic stack 111 were aligned with the corresponding external terminal electrodes 112D and 112E of the ceramic sintered compacts 112 previously provided on the constraining layer 114, and subsequently the green ceramic stack 111 and then the other constraining layer 114 were stacked in that order on the former constraining layer 114. The constraining layers 114 and the ceramic stack 111 were pressure-bonded at a predetermined pressure to prepare a green multilayer composite 120D shown in Fig. 7(a), in the same manner as in Example 1. In this state, an unfired chip-mounted substrate 110D lies between the upper and lower constraining layers 114. The ceramic sintered compacts 112 on the upper and lower surfaces of the green ceramic stack 111 are pressed into the green ceramic sintered compact 111 from its upper and lower surfaces to reduce the profile. The green multilayer composite 120D was fired in the same manner as in Example 1 to complete a chip-mounted substrate 10D shown in Fig. 7(b).

The present example can provide the chip-mounted substrate 10D having chip electronic components 12 on both the upper and the lower surface of the multilayer ceramic substrate 11. The external terminal electrodes 12D and 12E of the chip electronic components 12 and the surface electrodes 11C are sintered to be integrated and tightly fixed to each other, as in Example 1. Consequently, the same effects as in Example 1 were produced.

### EXAMPLE 7

The present example produced chip-mounted substrates in the same manner as in Example 1, except that the sintering agent content in the low-temperature co-fired ceramic material forming the constraining layers was varied to change the degree of shrinkage of the ceramic layers.

In the present example, the chip-mounted substrates were evaluated by X-ray flaw detection. The results are shown in Table 3. In Table 3, the "substrate" refers to the multilayer ceramic substrate and the "component" refers to the monolithic ceramic capacitor.

**[Table 3]**

| Sintering agent content (wt%) | Degree of shrinkage (%) | Effect on component | Remark |
|---|---|---|---|
| 1.7 | -5.1 | Cracked | Pressure firing |
| 1.6 | -5.0 | No problem | Pressure firing |
| 1.4 | -4.0 | No problem | Pressure firing |
| 1.3 | -3.0 | No problem | Pressure firing |
| 1.2 | -2.0 | No problem | Pressure firing |
| 1.0 | -1.0 | No problem | Pressure firing |
| 0.5 | 0 | No problem | Pressure firing |
| 0.42 | +0.03 | No problem | Non-pressure firing |
| 0.38 | +0.05 | No problem | Non-pressure firing |
| 0.3 | +1.0 | No problem | Non-pressure firing |
| 0.25 | +2.0 | No problem | Non-pressure firing |
| 0.2 | +3.0 | No problem | Non-pressure firing |
| 0.1 | +5.0 | No problem | Non-pressure firing |
| 0.0 | +5.1 | Separated from substrate | Non-pressure firing |

Table 3 shows that when the shrinkage of the ceramic layers is beyond -5%, the chip electronic components 12 cracked; when it is increased to more than +5%, the chip electronic components 12 are separated from the substrate. In other wards, it has been found that the degree of shrinkage of the low-temperature co-fired ceramic material needs to be controlled within ±5%. Accordingly, the sintering agent content in the low-temperature co-fired ceramic material forming the constraining layer is preferably set such that the shrinkage is within ±5% (in the range of 0.1 to 1.6 percent by weight). The shrinkage can be controlled by varying the grain size of Al₂O₃ in the shrinkage-constraining layer, the thickness of the shrinkage-constraining layer, or any other approach, in addition to varying the sintering agent (borosilicate) content in the shrinkage-constraining layer.

### EXAMPLE 8

The present example produced a chip-mounted substrate in the same manner as in Example 6, except that a cavity was formed in which the chip electronic components were mounted. In the present example, parts that are the same as or correspond to those in Example 1 are designated by the same numerals.

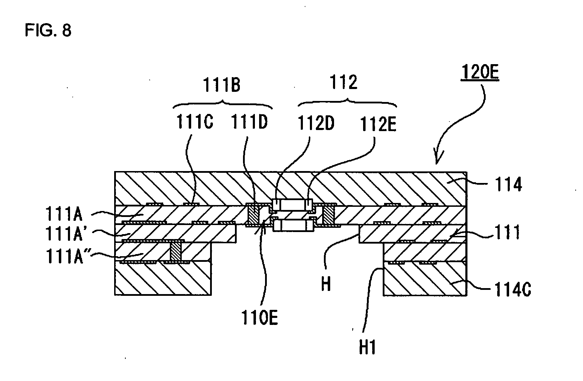

In the chip-mounted substrate of the present example, the chip electronic components are mounted on the upper and lower surfaces of the multilayer ceramic substrate as in Example 6, but the chip electronic components on the lower surface are housed in a cavity C, as imaged from Fig. 8. Hence, in the present example, the chip-mounted substrate was produced in the same manner as in Example 7, except that the chip electronic components were mounted in the cavity formed in the lower surface of the multilayer ceramic substrate.

In the present example, a predetermined number of ceramic green sheets 111A were formed, and the ceramic green sheets 111A were provided with in-plane conductors 111C and via conductors 111D forming wiring patterns 111B in predetermined patterns as required, as shown in Fig. 8, in the same manner as in Example 1. These ceramic green sheets 111A each have a thickness of 100 µm after firing. As shown in Fig. 8, one of the ceramic green sheets 111A was used for mounting the ceramic sintered compacts 112, and the other two ceramic green sheets were provided with respective through holes H and H1 with different sizes capable of housing the ceramic sintered compacts 112. These ceramic green sheets 111A' and 111A" were used for forming a cavity C. Also, another through hole H1 having the same size as the ceramic green sheet 111A" was formed in one of the constraining layers 114A.

Then, after an organic adhesive layer was formed on the upper surface of the other constraining layer 114 having no through hole, ceramic sintered compacts 112 being element assemblies of the chip electronic components were disposed in predetermined regions on the upper surface of the constraining layer 114, followed by bonding and fixing. Each in-plane conductor 111C of the ceramic green sheet 111A was aligned with the corresponding external terminal electrodes 112D, 112E of the ceramic sintered compacts 112 on the constraining layer 114, and subsequently the ceramic green sheet 111A was pressure-bonded to the upper surface of the constraining layer at a predetermined pressure.

Then, the two ceramic green sheets 111A' and 111A" respectively having the through holes H and H1 were stacked in that order on the ceramic green sheet 111A to form a green ceramic stack 111 having a cavity. The green ceramic stack 111 was provided with the constraining layer 114C having the through hole H1 on its upper surface, and pressure-bonded at a predetermined pressure to prepare a multilayer composite 120E shown in Fig. 8. The multilayer composite 120E in Fig. 8 is upside down, having a downward cavity. The green multilayer composite 120E was fired at 850°C to complete a chip-mounted substrate having the downward cavity C.

According to the present example, even if the surface of the multilayer ceramic substrate has such a complex shape as a cavity, ceramic sintered compacts 112 can be easily mounted on the substrate by use of a ceramic green sheet 111A having a flat upper surface. In addition, the external terminal electrodes of each chip electronic component can be sintered integrally with the corresponding surface electrodes and thus tightly fixed to the surface electrodes, as in Example 1. Consequently, the same effects as in Example 1 were produced.

### EXAMPLE 9

The present example produced a chip-mounted substrate in the same manner as in Example 3, except that a cavity was formed in the upper surface of the chip-mounted substrate in Example 3. In the present example, parts that are the same as or correspond to those in Example 3 are designated by the same numerals.

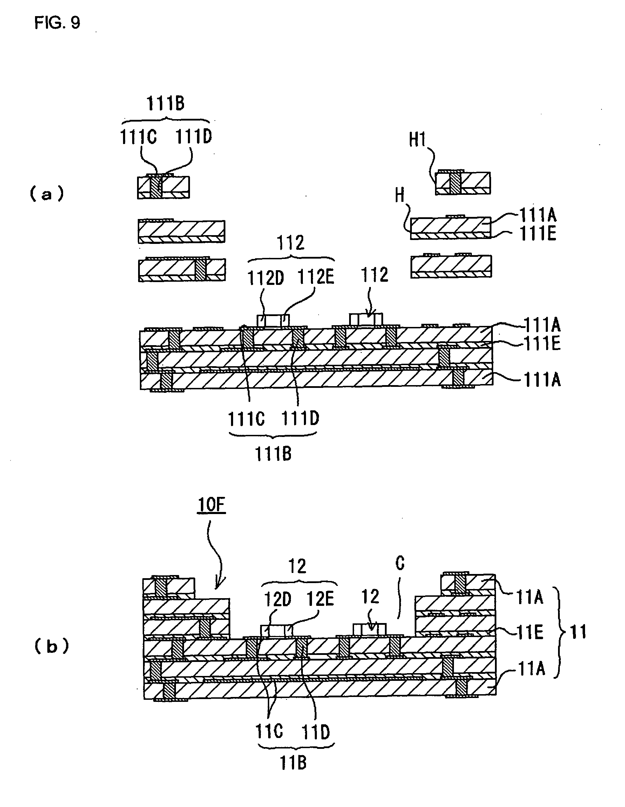

In the present Example, as shown in Fig. 9(a), a predetermined number (five in Fig. 9(a)) of ceramic green sheets 111A were each laminated with a constraining layer 111E to form composite sheets, in the same manner as in Example 3. The composite sheets were provided with in-plane conductors 111C and via conductors 111D forming wiring patterns 111B in predetermined patterns as required. The in-plane conductors 111C were formed on the ceramic green sheet of each composite sheet. Two of the composite sheets were provided with respective through holes H with the same size, and another composite sheet was provided with a larger through hole H1 than the through holes H of the two composite sheets. These composite sheets were used for forming a cavity C. The other two composite sheets, having no through holes, were used as a main composite defining the bottom of the cavity C. Another ceramic green sheet 111A was formed, and subsequently provided with in-plane conductors 111C and via conductors 111D forming a wiring pattern 111B.

Then, two composite sheets were stacked on the ceramic green sheet 111A and provisionally pressure bonded to form a main composite, as shown in Fig. 9(a). An organic adhesive layer was formed on the main composite. After the external terminal electrodes 112D and 112E of each ceramic sintered compact 112 were aligned with the corresponding surface electrodes 111C in the region intended as the bottom of the cavity, the ceramic sintered compact 112 was bonded and fixed to the surface electrodes 111C with the corresponding external terminal electrode 112D or 112E therebetween. Then, the two composite sheets having their respective through holes H and the single composite sheet having the through hole H1 were stacked in that order, and were subsequently pressure-bonded at a predetermined pressure to form an opening intended as the cavity (see Fig. 9(b)) over the upper surface of the main composite, thus forming a green ceramic stack 111. The green ceramic stack 111 was fired at 850°C to complete a chip-mounted substrate 10F having a cavity C (Fig. 9(b)). By this firing, the constraining layers 11E and the ceramic layers 11A overlying and underlying each constraining layer are tightly integrated into a multilayer ceramic substrate 11 by solidification of glass components diffused from the ceramic layers 11A. Also, the external terminal electrodes 12D and 12E of the chip electronic components 12 are integrally joined and tightly connected to the surface electrodes 11C on the bottom of the cavity C without using any bonding material, such as solder.

According to the present example, even if the surface of the multilayer ceramic substrate 11 has such a complex shape as the cavity C, chip electronic components 12 can be easily mounted on the substrate simply by disposing ceramic sintered compacts 112 on the upper surface of a main composite having a flat upper surface. In addition, the present example prevented the multilayer ceramic substrate 11 having a cavity from warping or waving, and provided the same effects as in Example 1.

### EXAMPLE 10

The present example produced a chip-mounted substrate in the same manner as in Example 3, except that an additional constraining layer was disposed on the lower surface of the green ceramic stack containing constraining layers. In the present example, parts that are the same as or correspond to those in Example 3 are designated by the same numerals.

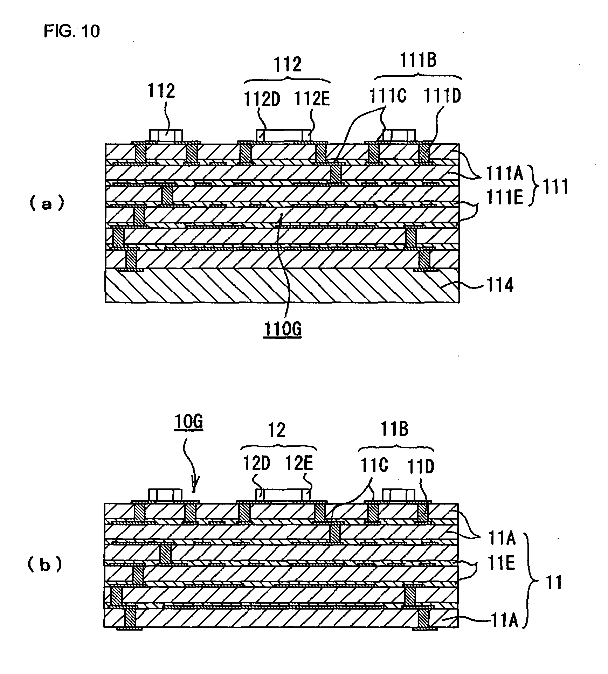

In the present example, a constraining layer 114 was formed as shown in Fig. 10(a), and a single ceramic green sheet 111A and five composite sheets formed in the same manner as in Example 3 were stacked on the constraining layer 114. The green ceramic stack 111 and the constraining layer 114 were pressure bonded at a predetermined pressure. The resulting unfired chip-mounted substrate 110G was fired at 850°C to complete a chip-mounted substrate 10G shown in Fig. 10(b).

The chip-mounted substrate 10G of 105 mm square and 0.5 mm thickness of the present example was measured for warp. The chip-mounted substrate 10A with the same dimensions produced in Example 3 was also measured for warp. The results are shown in Table 4.

**[Table 4]**

| | Degree of warp/mm |
|---|---|
| Example 3 | 0.154 |
| Example 10 | 0.104 |

Table 2 shows that the warp of the chip-mounted substrate 10G of the present example was still more reduced than that of the chip-mounted substrate 10A of Example 3. This means that by providing the constraining layer 114 on the lower surface of the green ceramic stack containing the constraining layers 111E, the warp or wave can further be reduced. In particular, when a cavity is formed in the upper surface of the multilayer ceramic substrate 11 as in Example 9, the warp or wave of multilayer ceramic substrate 11 can be further reduced.

### EXAMPLE 11

The present example produced a chip-mounted substrate in substantially the same manner as the chip-mounted substrate of Example 9, except that a constraining layer was formed on the lower surface of green ceramic layers having an opening acting as the cavity. In the present example, parts that are the same as or correspond to those in Example 9 are designated by the same numerals.

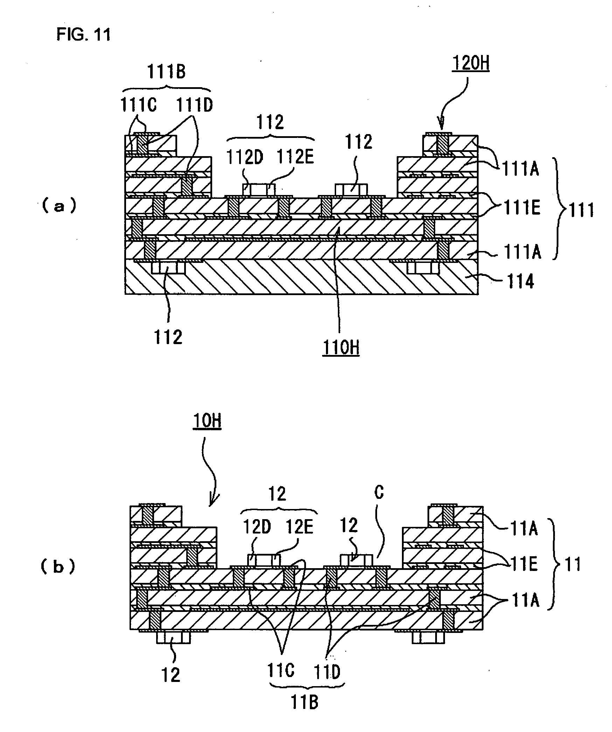

In the present example, two types of composite sheets having respective through holes H and H1 with different sizes are formed, and a ceramic green sheet 111A and composite sheets were formed for a main composite, as shown in Fig. 11(a), in the same manner as in Example 9. These ceramic green sheet 111A and composite sheets have their respective wiring patterns 111B (in-plane conductors 111C and via conductors 111D) in predetermined patterns. In the present example, another constraining layer 114 was further formed in the same manner as in Example 1.

Then, an organic adhesive layer was formed on the upper surface of the constraining layer 114, and ceramic sintered compacts 112 were disposed in predetermined regions of the constraining layer 114, as shown in Fig. 11(a), followed by bonding and fixing. After the external terminal electrodes 112D and 112E of the ceramic sintered compacts 112 on the constraining layer 114 were aligned with the corresponding surface electrodes 111C on the lower surface of the ceramic green sheet 111A, the ceramic green sheet 111A and two composite sheets were stacked and provisional pressure-bonded to form a main composite. After the main composite was provided with an organic adhesive layer on its upper surface, the ceramic sintered compacts 112 were bonded and fixed to the upper surface of the main composite, with the surface electrodes 111C in the region intended as the bottom of the cavity C (see Fig. 11(b)) aligned with the corresponding external terminal electrodes 112D and 112E of the ceramic sintered compacts 112. Then, two composite sheets each having a through hole H and a composite sheet having a through hole H1 were stacked in that order, and subsequently pressure-bonded at a predetermined pressure to form an opening acting as the cavity over the upper surface of the main composite. Thus, a green ceramic stack 111 shown in Fig. 11(a) was formed on the constraining layer 114 to repaper a multilayer composite 120H. The green multilayer composite 120H was fired at 850°C, and subsequently the constraining layer 114 was removed to complete a chip-mounted substrate 10H having a cavity (see Fig. 11(b)). By this firing, the constraining layers 11E and the ceramic layers 11A overlying and underlying each constraining layer are tightly integrated into a multilayer ceramic substrate 11 by solidification of glass components diffused from the ceramic layers 11A. Also, the external terminal electrodes 12D and 12E of the chip electronic components 12 are integrally joined and tightly connected to the surface electrodes 11C on the bottom of the cavity C without using any bonding material, such as solder. Reference numeral 110H designates an unfired chip-mounted substrate formed on the constraining layer 114.

According to the present example, even if the surface of the multilayer ceramic substrate 11 has such a complex shape as the cavity C, chip electronic components 12 can be easily mounted on the substrate simply by disposing ceramic sintered compacts 112 on the upper surface of a main composite having a flat upper surface. In addition, the present example prevented the multilayer ceramic substrate 11 from warping or waving, and provided the same effects as in Example 1.

### EXAMPLE 12

The chip-mounted substrate of the present example has the same structure as the chip-mounted substrate 10 of Example 1, except for the structure of the external electrodes of monolithic ceramic capacitors, or the chip electronic components. Hence, the present example can produce the chip-mounted substrate in the same manner as in Example 1. The following description shows only the structure of the chip electronic component. In the present example, parts that are the same as or correspond to those in Example 9 are designated by the same numerals.

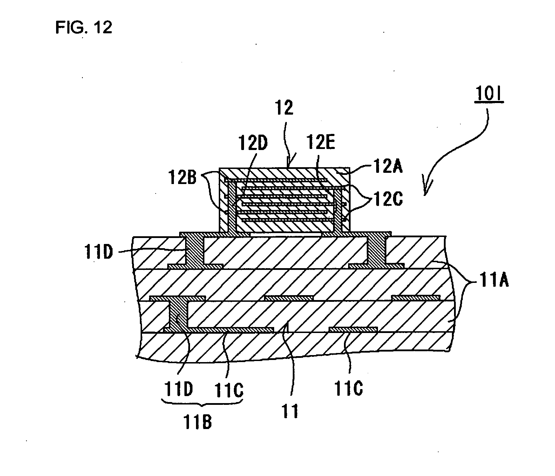

The chip electronic component 12 used in the present example is a monolithic ceramic capacitor as shown in Fig. 12. The chip electronic component 12 includes a stack of a plurality of dielectric ceramic layers 12A; a plurality of internal electrode layers 12B and 12C, each lying between its overlying and underlying dielectric ceramic layers 12A, and opposing the dielectric ceramic layers 12A; and a pair of external terminal electrodes 12D and 12E formed as the via conductors inside the stack to the right side and the left side, extending through the centers of one ends of the plurality of internal electrode layers 12B and 12C, as shown in Fig. 12. One electrode 12D of the external terminal electrodes formed as the via conductors is connected to all the internal electrode layers 12B, or either part of the alternately extending internal electrode layers, and the lower end of the external electrode 12D is exposed at the lower surface of the stack. The other external terminal electrode 12E is connected to all the internal electrode layers 12C, or the other part of the alternately extending internal electrode layers, and the lower end of the external electrode 12E is exposed at the lower surface of the stack. The other parts of the monolithic ceramic capacitor have the same structures as in Example 1.

In the present example, the via conductors used as the external terminal electrodes 12D and 12E of the chip electronic component 12 are sintered integrally with the surface electrodes 11C on the surface of the multilayer ceramic substrate 11 and thus tightly connected to them at the bottom of the component. Consequently, the present example produced the same effects as Example 1. Specifically, it has been found that even if the external terminal electrodes 12D and 12E of a chip electronic component 12 are provided in any form, the surface electrodes 11C on the upper surface of the multilayer ceramic substrate 11 can be firmly and tightly connected to the external terminal electrodes 12D and 12E of the chip electronic component 12 without using any bonding material, such as solder.

While each example above used a ceramic substrate formed of a low-temperature co-fired ceramic material, the ceramic material of the ceramic substrate is not limited to the low-temperature co-fired ceramic material, and a high-temperature co-fired ceramic material may be used which is prepared by adding a sintering agent to a ceramic material, such as alumina, aluminium nitride, and mullite, and which are fired at a high temperature of 1050°C or more. In use of the high-temperature co-fired ceramic material, the electrodes may be formed of, for example, molybdenum, platinum, palladium, tungsten, or nickel, or an alloy of these metals. Also, while the examples each used a multilayer ceramic substrate formed by stacking a plurality of ceramic layers, the ceramic substrate may be as a single ceramic layer.

The present invention is not limited to the above-described examples, and the invention includes any form as long as the external terminal electrodes of the chip electronic component are integrated with the surface electrodes of a ceramic substrate by sintering, without using any bonding material, such as solder.

### Industrial Applicability

The present invention can be advantageously applied to, for example, chip electronic component-mounted ceramic substrates used in various types of electronic apparatuses.

## Claims

1. A method for manufacturing a chip electronic component-mounted ceramic substrate, comprising the steps of:
mounting a chip electronic component including a ceramic sintered compact being an element assembly and terminal electrodes, on a ceramic green body having conductors thereon such that the terminal electrodes are brought into contact with the corresponding conductors; and,
firing the ceramic green body having the chip electronic component so as to integrate the conductors on the ceramic green body with the corresponding terminal electrodes of the chip electronic component by sintering.

2. The method for manufacturing a chip electronic component-mounted ceramic substrate according to Claim 1, wherein the ceramic green body is defined by a ceramic green sheet, and a green ceramic stack formed by stacking the ceramic green sheet having the chip electronic component and other ceramic green sheets is fired.

3. The method for manufacturing a chip electronic component-mounted ceramic substrate according to Claim 2, further comprising the step of forming a constraining layer on the uppermost layer or an internal layer of the green ceramic stack, the constraining layer mainly containing a sintering-resistant powder that is not substantially sintered at the sintering temperature of the ceramic green sheets.

4. The method for manufacturing a chip electronic component-mounted ceramic substrate according to Claim 3, wherein the constraining layer is a sheet containing the sintering-resistant powder and an organic binder.

5. The method for manufacturing a chip electronic component-mounted ceramic substrate according to Claim 4, wherein the sheet of the constraining layer is formed on the uppermost layer of the green ceramic stack, and the method further comprises the step of pressure-bonding the constraining layer to press the chip electronic component into the ceramic green sheet.

6. The method for manufacturing a chip electronic component-mounted ceramic substrate according to Claim 5, wherein the green ceramic stack having the constraining layer is fired with a pressure of 0.1 to 10 MPa applied.

7. The method for manufacturing a chip electronic component-mounted ceramic substrate according to Claim 3, wherein the constraining layer is formed of a green compact of the sintering-resistant powder on the uppermost surface of the green ceramic stack.

8. The method for manufacturing a chip electronic component-mounted ceramic substrate according to Claim 1, further comprising the step of forming a constraining layer in a sheet form having via conductors arranged corresponding to the terminal electrodes of the chip electronic component, on the ceramic green body to form the conductors, wherein the constraining layer contains a sintering-resistant powder that is not substantially sintered at the sintering temperature of the ceramic green body and an organic binder.

9. The method for manufacturing a chip electronic component-mounted ceramic substrate according to any one of Claims 1 to 8, wherein the chip electronic component is mounted on the conductors of the ceramic green body with an organic adhesive therebetween.

10. The method for manufacturing a chip electronic component-mounted ceramic substrate according to any one of Claims 1 to 9, wherein the ceramic green body is defined by a ceramic green sheet mainly containing a low-temperature co-fired ceramic powder, and the terminal electrodes of the chip electronic component and the conductors on the ceramic green sheet are formed of an electrode material mainly containing silver, copper, or gold.

11. A chip electronic component-mounted ceramic substrate comprising: a ceramic substrate having surface electrodes; and a chip electronic component mounted on the ceramic substrate, the chip electronic component including a ceramic sintered compact as an element assembly and terminal electrodes, wherein the surface electrodes of the ceramic substrate are integrated with the corresponding terminal electrodes of the chip electronic component by sintering.

12. A chip electronic component-mounted ceramic substrate comprising: a ceramic substrate having surface electrodes; and a chip electronic component mounted on the ceramic substrate, the chip electronic component including a ceramic sintered compact as an element assembly and terminal electrodes, wherein the surface electrodes of the ceramic substrate are connected to the corresponding terminal electrodes of the chip electronic component in a filletless manner without using solder or electroconductive adhesive.

13. The chip electronic component-mounted ceramic substrate according to Claim 11 or 12, wherein the surface electrodes are bump electrodes.

14. The chip electronic component-mounted ceramic substrate according to Claim 11 or 12, wherein at least part of the chip electronic component is embedded in the surface of the ceramic substrate.

15. The chip electronic component-mounted ceramic substrate according to any one of Claims 11 to 14, wherein the ceramic substrate is a multilayer ceramic substrate comprising a plurality of low-temperature co-fired ceramic layers stacked one on top of another, and the terminal electrodes of the chip electronic component and the surface electrodes of the multilayer ceramic substrate mainly contain silver, copper, or gold.
